(19) Europäisches Patentamt
European Patent Office
Office européen des brevets

(11) **EP 0 447 815 B1**

(12) **EUROPEAN PATENT SPECIFICATION**

(45) Date of publication and mention
of the grant of the patent:
**28.05.1997 Bulletin 1997/22**

(51) Int Cl.⁶: **G11B 11/10**, G11B 13/04,
G11B 7/125, G02F 1/09,
G02F 1/015

(21) Application number: **91102350.5**

(22) Date of filing: **19.02.1991**

(54) **Magnetooptic device**

Magnetooptisches Gerät

Dispositif magnéto-optique

(84) Designated Contracting States:
**BE CH DE ES FR GB IT LI NL SE**

(30) Priority: **20.02.1990 JP 39265/90**

(43) Date of publication of application:
**25.09.1991 Bulletin 1991/39**

(73) Proprietor: **CANON KABUSHIKI KAISHA
Tokyo (JP)**

(72) Inventors:
• **Yamanishi, Masamichi
Hiroshima-shi, Hiroshima-ken (JP)**

• **Oda, Hitoshi, c/o CANON KABUSHIKI KAISHA
Ohta-ku, Tokyo (JP)**

(74) Representative:
**Bühling, Gerhard, Dipl.-Chem. et al
Patentanwaltsbüro
Tiedtke-Bühling-Kinne & Partner
Bavariaring 4
80336 München (DE)**

(56) References cited:
**EP-A- 0 309 988        EP-A- 0 328 214
EP-A- 0 361 236**

**Description**

BACKGROUND OF THE INVENTION

Field of the Invention

The present invention relates to a magnetooptic device to control a degree of a magnetooptic effect by applying an electric field and a method of driving such a device. The magnetooptic device of the invention is suitably used as, for instance, an optical modulator or an optical isolator in the field of an optical communication or an optical memory.

Related Background Art

In recent years, the optical fiber communication using a semiconductor laser or the like as a light source and an optical memory using an optical disk, a magnetooptic disk, or the like have been developed in association with the realization of a high transmission speed of information and a large recording capacity of information. Those systems need an optical device having a variety of functions.

For instance, in the optical communication such as an optical fiber communication or the like, a system using an external optical modulator to further increase a bit rate is studied. According to such a system, since the semiconductor laser is DC driven, an optical pulse train of a narrow spectrum width and a high quality can be obtained.

As specifications of such an optical modulator, it is required that a high speed modulation of about 10 Gbps can be performed and a large modulation amplitude of 10 dB or more is provided. An optical modulator having a structure which satisfies such specifications and is suitable for further miniaturization and high integration is now being developed. However, the development is still insufficient.

On the other hand, in the above optical communication and optical memory, an instability of the oscillation and noises due to the return light of the semiconductor laser always cause a problem. An optical isolator is known as only one device to completely prevent that such a return light enters the semiconductor laser. High integration and miniaturization of the optical isolator and the semiconductor laser are now being studied. However, there are still several problems with respect to such a study.

A conventional example of the above optical modulator and the optical isolator will now be further practically described hereinbelow.

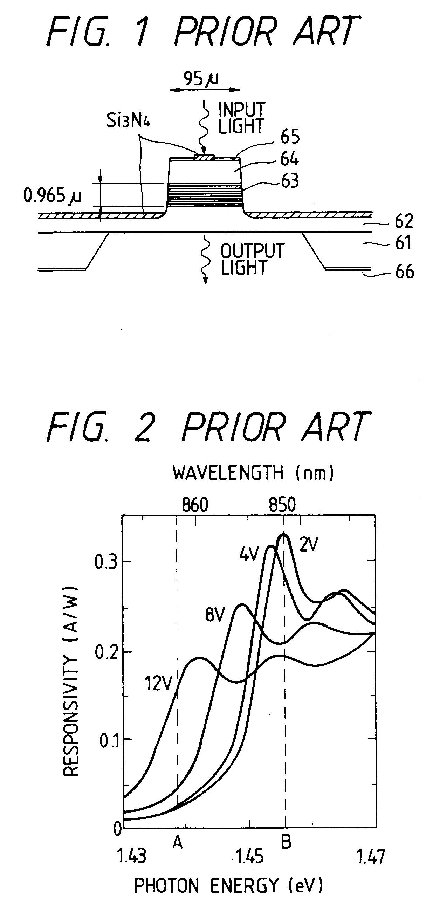

An optical modulator using a quantum confined Stark effect (QCSE) has been proposed in "Quantum Electron", IEEE J., Vol. QE-21, page 117, 1985, "Quantum Electron", IEEE J., Vol. QE-21, page 1462, 1985, or the like. Fig. 1 shows a schematic cross sectional view of an example of such an optical modulator.

In Fig. 1, an $n^+$-A$\ell$GaAs layer 62, an intrinsic (i-) multiple quantum well (MQW) layer 63, and a $p^+$-A$\ell$GaAs layer 64 are sequentially formed as films on an $n^+$-GaAs substrate 61. A hole to transmit the light is formed in the substrate 61 by a selective etching process. Electrodes 66 and 65 are formed under the lower surface of the substrate 61 and on the $p^+$-A$\ell$GaAs layer 64, respectively.

The i-MQW layer 63 is constructed by alternately laminating a GaAs layer as a well layer and an A$\ell$GaAs layer as a barrier layer. When an inverse-bias voltage is applied to a pin structure constructed as mentioned above, as shown in Fig. 2, as a value of the applied voltage increases, an exciton absorption peak decreases and an absorption edge moves to the long wavelength side, that is, what is called a red-shift occurs.

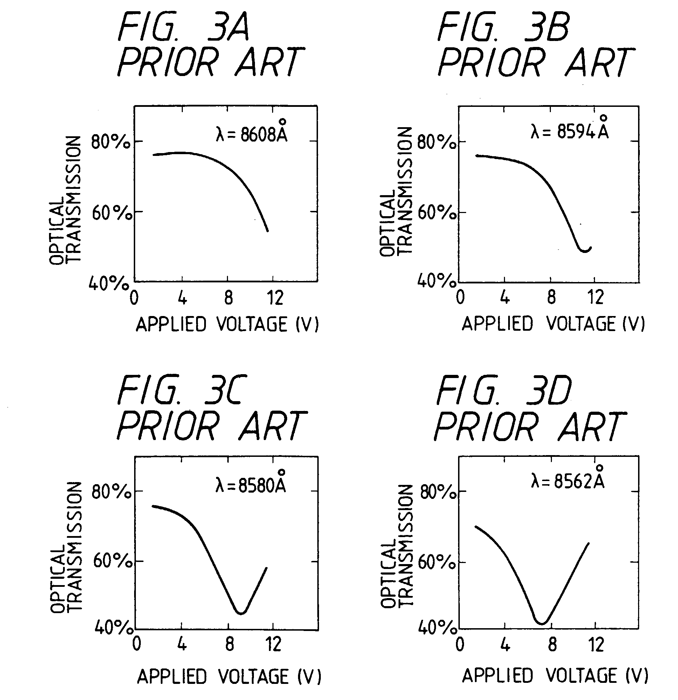

Therefore, as shown in A or B in Fig. 2, by setting a wavelength of an input light to the device to a predetermined value and by changing the voltage which is applied to the device, a transmittance of the input light of a set wavelength $\lambda$ can be changed as shwon in Figs. 3A to 3D. The optical modulator of Fig. 1 intends to modulate a transmission light amount by using such an effect.

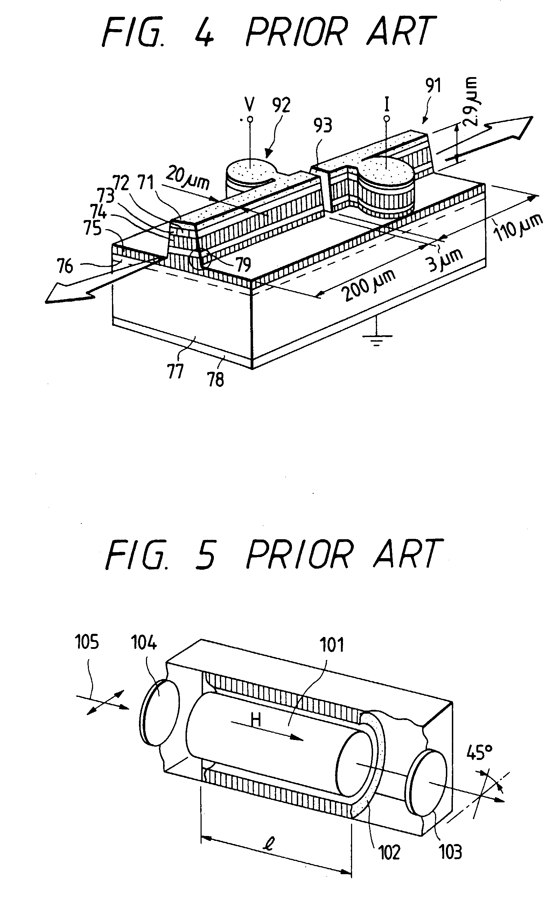

On the other hand, a device which is constructed by integrating a semiconductor laser and an external optical modulator has been proposed in "Japan J. Applied Physics", Vol. 24, L442, 1985. Fig. 4 shows a schematic perspective view of such a device.

In Fig. 4, reference numeral 77 denotes an $n^+$-GaAs substrate; 76 an $n^+$-GaAs layer; 75 an n-A$\ell_y$Ga$_{1-y}$ As layer (y = 0.3); 79 an MQW layer; 74 a p-A$\ell_y$Ga$_{1-y}$As layer (y = 0.3); 73 an Si$_3$N$_4$ layer; 72 a $p^+$-GaAs layer; 78 an n-type electrode; and 71 a p-type electrode. A stripe-shaped optical waveguide is formed by mesa-etching the upper portion of the $n^+$-A$\ell_y$Ga$_{1-y}$ As layer 75. The device is separated into a laser section 91 and a modulator section 92 by a groove 93.

As mentioned above, the laser section 91 and the modulator section 92 have the same pin structure. The waveguides of those sections are optically coupled. Therefore, the light emitted from the laser section 91 enters the waveguide of the modulator section 92 and is waveguided by a predetermined distance and, thereafter, it is emitted. At this time, by applying an inverse-bias voltage to the modulator section 92, the waveguided light is absorbed by the foregoing QCSE in accordance with the applied voltage value. That is, an intensity of the light which is emitted from the modulator section 92 can be modulated by the control of the applied voltage.

Fig. 5 shows a conventional example of the optical isolator. A material having a large magnetooptic effect such as a paramagnetic glass 101 is put into a hollow cylindrical permanent magnet 102 and a magnetostatic field H is applied to the glass 101. A laser beam 105 which becomes a linear polarization light by passing through a polarizing plate 104 is input to the glass 101. In this case, a polarizing direction of the laser beam 105 is rotated by 45° by a Faraday effect when the laser beam transmits the paramagnetic glass 101.

A polarizing plate 103 on the emission light side is arranged so that an angle between a main axis of the polarizing plate 103 and a main axis of the polarizing plate 104 on the incident light side is set to 45°. Therefore, the laser beam 105 whose polarizing direction was rotated as mentioned above directly passes through the polarizing plate 103. On the other hand, the polarizing direction of the return light which enters from the side of the polarizing plate 103 is also rotated for a period of time when the return light passes through the polarizing plate 103 and reversely moves in the paramagnetic glass 101. An angle between the polarizing direction of the return light and the main axis of the polarizing plate 104 on the incident light side is set to 90°. Thus, the return light cannot pass through the polarizing plate 104 on the incident side and is cut.

An isolation ratio (of a degree such as to cut the return light) of the device depends on the Faraday rotation angle. The Faraday rotation angle $\theta_F$ is given by

$$\theta_F = V\ell H$$

when the light passes through a material such as an above paramagnetic glass having a length of $\ell$. In the above equation, V denotes a Verdet's constant and H indicates a magnitude of an external magnetic field. At this time, to set the angle $\theta_F$ to 45° in order to maximize the isolation ratio, it is necessary to accurately adjust the length $\ell$ of the paramagnetic glass 101 and the magnetostatic field H by the permanent magnet 102.

However, the above conventional device has the following problems.

First, there is a problem such that the modulation amplitude of the optical modulator as shown in Figs. 1 to 4 is shallow. For example, the modulation amplitude is merely about 50% (3dB) as shown in Figs. 3A to 3D. In the case of using the optical modulator for the optical communication or the like, a modulation amplitude of at least 10 dB or more is generally necessary. Therefore, it is a present situation that the foregoing optical modulator is not used as a practical device.

There is also a problem such that the optical isolator as shown in Fig. 5 must be manufactured at a high dimensional accuracy by using a material having a large magnetooptic effect. It is also necessary to accurately control the external magnetic field. That is, the values of $\ell$ and H must be accurately set so as to set the Faraday rotation angle $\theta_F$ to 45° at a high precision.

SUMMARY OF THE INVENTION

It is an object of the present invention to solve the problems of the conventional techniques as mentioned above and to provide a magnetooptic device which can control a degree of magnetooptic effect by applying an electric field and also to provide a method of driving such a device.

The above object of the invention is accomplished by a magnetoopic device comprising: a substrate; a semiconductor layer having a quantum well structure formed on the substrate, in which the semiconductor layer is formed by alternately laminating a well layer and a barrier layer and at least the barrier layer in said layers contains ions having a magnetic moment; means for applying a magnetic field to the semiconductor layer; and electrodes to apply an electric field to the semiconductor layer.

On the other hand, the above object is also accomplished by a method of driving the above magnetooptic device, comprising the steps of:
inputting a light which is polarized in a predetermined direction to the semiconductor layer; applying a magnetic field to the semiconductor layer; applying the electric field to the semiconductor layer by the electrode; and extracting the light which is transmitted through the semiconductor layer.

According to the invention, by applying the electric field from the electrode to the semiconductor layer, a magnitude of the leakage of a wave function of the charge carrier in the well layer into the barrier layer changes and an effective magnetic field acting on a charge carrier changes by an exchange interaction between the charge carrier spin and the magnetic moment associated with the having a magnetic moment ions. Thus, a degree of magnetooptic effect which is given to the light which is transmitted in the semiconductor layer changes.

By applying the invention, an optical modulator having a larger modulation amplitude than that in the conventional device can be realized. By applying the invention to the optical isolator, the polarizing direction of the light can be adjusted by applying an electric field. Therefore, there is no need to accurately control an intensity of the external magnetic field and a manufacturing precision of the isolator which is required is also lightened.

## BRIEF DESCRIPTION OF THE DRAWINGS

Fig. 1 is a schematic cross sectional view showing an example of a conventional optical modulator;

Fig. 2 is a diagram showing a light absorption spectrum of the optical modulator in Fig. 1;

Figs. 3A to 3D are diagrams showing the relation between the applied voltage and the transmittance in the optical modulator of Fig. 1;

Fig. 4 is a schematic perspective view showing an example of a conventional device which is constructed by integrating a semiconductor laser and an optical modulator;

Fig. 5 is a perspective view with a part cut away showing an example of a conventional optical isolator;

Fig. 6A is a schematic cross sectional view of a quantum well layer in the device of the invention;

Fig. 6B is a diagram showing an energy band of the quantum well layer in Fig. 6A;

Fig. 7A is a diagram showing distribution of a wave function of the charge carrier and an effective magnetic field intensity in the device of the invention in a state in which no voltage is applied;

Fig. 7B is a diagram showing a distribution of a wave function of the charge carrier and an effective magnetic field intensity in the device of the invention in a state in which a voltage wave applied;

Fig. 8 is a perspective view with a part cut away showing an embodiment of an optical modulator to which the invention was applied;

Fig. 9 is a diagram showing a light absorption spectrum in the optical modulator in Fig. 8;

Fig. 10 is a diagram showing the relation between the wavelength of light and the Faraday rotation angle in the optical modulator in Fig. 8; and

Fig. 11 is a schematic perspective view showing an embodiment of an optical isolator to which the invention was applied.

## DETAILED DESCRIPTION OF THE PREFERRED EMBODIMENTS

The operation principle of a magnetooptic device of the invention will be first described.

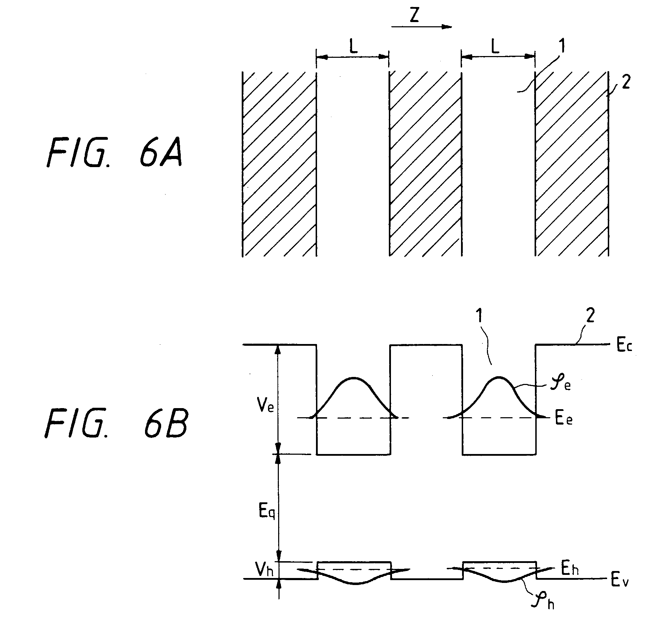

The magnetooptic device of the invention has an MQW structure as shown in a schematic cross sectional view of Fig. 6A. The MQW structure is formed by alternately laminating a quantum well layer 1 having a thickness of L and a barrier layer 2 shown as a hatched region. Fig. 6B shows an energy band of the MQW structure of Fig. 6A. An energy gap $E_g$ of the quantum well layer 1 is smaller than that of the barrier layer 2. Quantum wells having energy depths of $V_e$ and $V_h$ are formed in a conductive band shown by an energy level $E_c$ and a valence band shown by an energy level $E_v$, respectively. Quantum levels $E_e$ and $E_h$ exist in the quantum wells, respectively.

The barrier layer 2 is a magnetic semiconductor layer and contains ions having a magnetic moment of Fe, Mn, and the like and magnetic moments are distributed at random. The well layer 1 is made of a semiconductor material and can contain the ions having a magnetic moment or don't need to contain the ions having a magnetic moment. As material systems suitable to form the well layer 1 and the barrier layer 2, a CdTe/CdMnTe system, a ZnSe/ZnMnSe system, a CdS/CdMnS system, a CdSe/CdMnSe system, an HgSe/HgMnSe system, an HgTe/HgMnTe system, and the like can be mentioned. In all of the above systems, the layer containing the Mn ions is used as a barrier layer.

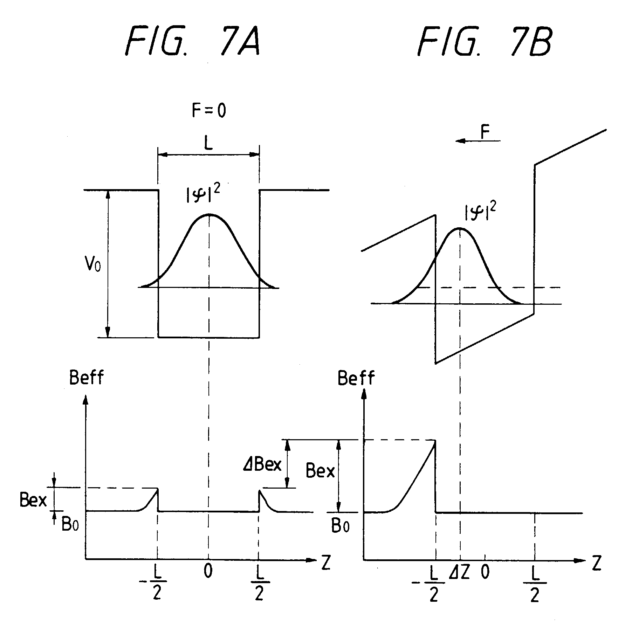

An electric field F and a magnetic field $B_0$ are simultaneously vertically (Z direction in Fig. 6A) applied to the quantum well layer 1. When a single quantum well having a width L as shown in Fig. 7A is considered for simplicity of explanation and a potential height assumes $V_0$, a Hamiltonian to describe the motion of the charge carrier in the Z axis is obtained by the following equation (1) on the basis of the theory disclosed in "Solid State Commun.", Vol. 57, page 853, 1986 or the like.

$$h(z) = \frac{P_z^2}{2m} + \theta(|z|-\frac{L}{2}) \{V_0 - V_m(z)\} + eFz \tag{1}$$

The center of the quantum well is set to an origin of the z axis. $\theta(x)$ denotes a step function. $V_m(z)$ indicates a potential which is generated by the magnetic interaction and shows an exchange interaction between the magnetic moment in the barrier layer which was induced by the external magnetic field $B_0$ and the spin of the charge carrier in the quantum well. $P_z$ denotes a momentum of the charge carrier having a mass of m and a charge of e. The exchange interaction $V_m(z)$ in the equation (1) is expressed as follows if an average field approximation is used.

$$V_m(z) = \alpha \cdot J^z \cdot S \cdot N \cdot B_s (g\mu_B B_{eff}/kT) \tag{2}$$

$\alpha$ denotes an exchange interaction constant between the charge carrier and the ion having a magnetic moment; $J^z$ a z component of the charge carrier spin; S a size of spin of the ion having a magnetic moment; N the number of, ions having a magnetic moment in a unit volume; $B_s(x)$ a Brillouin function; g a g factor; $\mu_B$ Bohr magneton; k Boltzmann's constant; and T a temperature.

$B_{eff}$ in the equation (2) indicates an effective magnetic field which acts on the charge carrier and is expressed as follows.

$$B_{eff} = B_0 + B_{ex}(z) \tag{3}$$

The second term of the right side in the equation (3) denotes an internal magnetic field which is caused by the exchange interaction with the ions having a magnetic moment due to a leakage of the charge carrier from the quantum well into the barrier layer and is expressed as follows.

$$B_{ex}(z) = \frac{\alpha J^z S}{g\mu_B} |\psi(\vec{r})|^2 \, \theta \left(|z| - \frac{L}{2}\right) \tag{4}$$

$\psi$ denotes a wave function of the charge carrier in the well layer which is obtained from a wave equation based on the equation (1). It will be understood from the equations (3) and (4) that the effective magnetic field $B_{eff}$ which actson the charge carrier increases as the wave function $\psi$ leaks into the barrier layer.

As shown in Fig. 7B, the electric field F deforms the wave function $|\psi|^2$ by inclining the potential, thereby raising an existence probability of the charge carrier in the barrier layer. Thus, it will be understood that the effective magnetic field $B_{eff}$ which acts on the charge carrier changes by turning on/off the electric field as shown in Figs. 7A and 7B. This means that a degree of magnetooptic effect such as a Faraday rotation angle can be modulated by the electric field F.

Examination will now be made to see a degree of an internal magnetic field $B_{ex}$ which can be modulated by the control of the electric field. A difference $\Delta B_{ex}$ of the internal magnetic fields $B_{ex}$ in the cases where the electric field F was applied and where it is not applied at the well edge (z = -L/2) is expressed as follows.

$$\Delta B_{ex} = \frac{\alpha J^z S}{g\mu_B}\left\{ \left| \psi\left(-\frac{L}{2}\right) \right|^2_{F\neq 0} - \left| \psi\left(-\frac{L}{2}\right) \right|^2_{F=0} \right\} \quad \cdots (5)$$

When assuming a Gaussian function as a wave function $\psi$, it is expressed as follows.

$$\psi(\vec{r}) = \psi(z, \vec{R}) = \frac{\eta \sqrt{a}}{\pi^{3/4}} \cdot \exp\left(-\frac{1}{2}a^2 z^2\right) \exp$$

$$\left(-\frac{1}{2}\eta^2 R^2\right) \tag{6}$$

$\vec{R}$ denotes a component which is parallel with an interface of a position vector $\vec{r}$. a and n denote parameters indicative of extents of the wave function in the directions which are perpendicular to and parallel with the interface, respectively.

When it is assumed that only the central position of the wave function (with a distribution shape unchanged) deforms by only $\Delta z$ as shown in Fig. 7B by applying the electric field F, the difference $\Delta B_{ex}$ of the internal magnetic fields in the equation (5) is expressed as follows.

$$\Delta B_{ex} = \frac{\alpha J^z S}{g\mu_B} \cdot a^2 \cdot L \cdot \Delta z \left| \psi\left(-\frac{L}{2}, \vec{R}\right) \right|^2 \tag{7}$$

$\Delta z$ is proportional to the magnitude of the electric field F and is expressed as follows.

$$\Delta z = -\frac{\sqrt{\pi}\ eF}{2V_0 a^3 L} \tag{8}$$

For instance, when CdTe is used as a quantum well layer and CdMnTe is used as a barrier layer, the change $\Delta B_{ex}$ in internal magnetic field in the case where the electric field F was applied to the potential well for the holes which are formed in the valence band is now calculated.

It is now assumed that a height $V_0$ of the potential barrier is set to 50 meV and a thickness L of the well layer is set to 5 nm (50 Å) and an extent (expressed by $a^{-1}$ and $\eta^{-1}$) of the wave function is set to 2,5 nm (25Å). In CdMnTe, a magnitude $\alpha$ of the exchange interaction between the hole spin and the magnetic moment of the $Mn^{2+}$ ions is large because of the P-d interaction and is obtained as -0.88 $eV/N_0$. $N_0$ denotes the number of Cd site in a unit volume. A technique regarding the value of $\alpha$ has been disclosed in, for example, "Japan Applied Physics", Vol. 64, R29, 1988.

The equation (7) can be calculated from the equations (8) and (6) by assuming that $J^z = 3/2$ and $S = 5/2$. When the electric field F (= $10^5$ V/cm) is applied, $\Delta B_{ex}$ is calculated as follows.

$$\Delta B_{ex} \simeq 6,4\ T\ (64\ kG)$$

This means that the modulation of the internal magnetic field of at most about 1T (10 kG) is caused by applying the electric field of 100 kV/cm. Such a value is very large when considering that a magnetic field which can be applied by a permanent magnet or an electromagnet is generally equal to up to 1T (10 kG). Further, since the electric field can be modulated at a rate of tens of GHz, the internal magnetic field can be also modulated at the same rate as above. When considering the case where the external magnetic field was modulated by controlling a current which is supplied to an electromagnet, an upper limit value of the modulation rate is equal to tens of MHz due to an increase in internal impedance. By comparing with such a case, it will be understood that the modulation rate according to the device of the invention is extremely high.

The device according to the invention uses the principle such that a degree of magnetooptic effect is modulated by controlling the applied electric field as mentioned above. Such a device can be used as an optical modulator of a high speed and a large modulation amplitude or an optical isolator having a high isolation ratio.

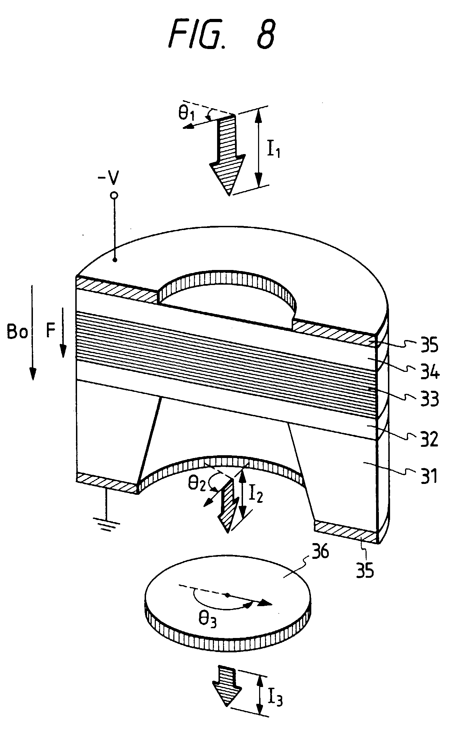

Fig. 8 is a perspective view with a part cut away showing an example of a high speed optical modulator having a large modulation amplitude to which the invention was applied.

In the diagram, an In doped n-CdMnTe layer 32 (having a thickness of 0.5 μm), an MQW layer 33 of CdTe/CdMnTe, and an As doped p-CdMnTe layer 34 (having a thickness of 0.5 μm) are sequentially laminated on an $n^+$-GaAs substrate 31 by a molecular beam epitaxy (MBE) method or an organic metal chemical vapor deposition (MO-CVD) method. Those layers have a pin structure. Electrodes 35 are formed under the lower surface of the substrate 31 and on the upper surface of the CdMnTe layer 34, respectively. Holes to transmit the light are formed in the electrodes 35 and the substrate 31.

The MQW layer 33 is formed by alternately laminating a CdTe layer having a thickness of 5 nm (50 Å) as a well layer and a CdMnTe layer having a thickness of 10 nm (100 Å) as a barrier layer. A whole layer thickness is equal to 1 μm.

A magnetostatic field $B_0$ (~ 0,5 T (5 kG)) is applied to the device with the above construction in the direction perpendicular to the film. A voltage of 10V of an inverse bias is also simultaneously applied while being modulated. When the voltage is applied, a field intensity which is applied to the MQW layer 33 is set to 100 kV/cm.

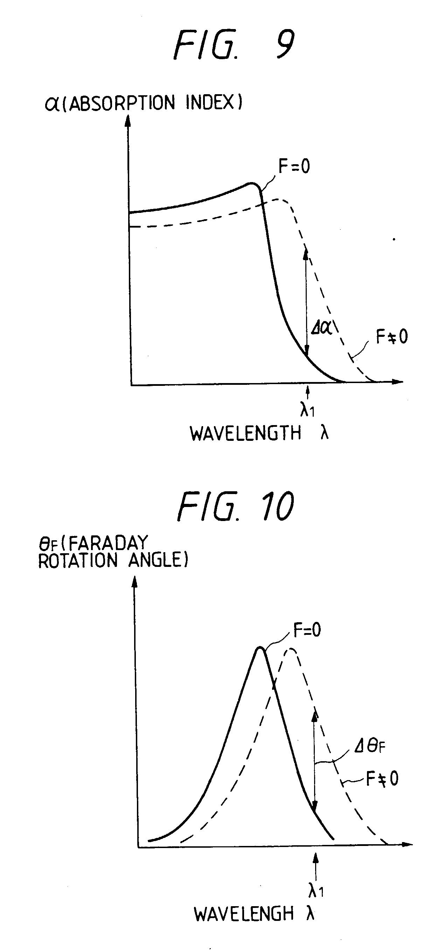

In this case, wavelength dependencies of the absorption index $\alpha$ and the Faraday rotation angle $\theta_F$ of the MQW layer 33 under the constant external magnetic field $B_0$ are as shown in Figs. 9 and 10, respectively. That is, as will be understood from Fig. 9, the absorption characteristics exhibit the red-shift by applying the electric field F ($\neq 0$) in a manner similar to the ordinary QCSE. On the other hand, as will be understood from Fig. 10, the Faraday rotation angle is modulated by the change (in this case, about 6,4 T (64 kG)) in internal magnetic field as mentioned above.

Therefore, by setting a wavelength of input light to the device to $\lambda_1$ in Figs. 9 and 10, the transmission light is simultaneously subjected to the intensity modulation and the modulation of the plane of polarization and is emitted from the device.

As shown in Fig. 8 when a linear polarization light which has an intensity of $I_1$ and whose polarizing direction is inclined at an angle of $\theta_1$ from a reference plane enters the device, the light is changed to the light having a light intensity of $I_2$ by a change $\Delta\alpha$ in absorption index by the QCSE in the case where the applied voltage is changed between 0V to 10V and is transmitted through the device. The polarizing direction of the transmission light is rotated by a Faraday effect so as to have an angle of $\theta_2$ from the reference plane.

By further passing the transmission light through a polarizer 36 whose main axis is inclined at an angle of $\theta_3$ from the reference plane, a change $\Delta\theta_F$ in Faraday rotation angle is converted into an intensity change and the light having an intensity 13 is finally obtained. Now, there is a relation of $\Delta\theta_F = \theta_2 - \theta_1$.

Therefore, a magnitude of the modulation between the cases where the inverse-bias voltage was applied and where it is not applied is proportional to

$$\Delta\alpha \times \Delta\theta_F$$

It will be understood that the modulation amplitude of the optical modulator according to the invention is large when considering that only $\Delta\alpha$ is used in the modulation by the ordinary QCSE. When also comparing with the case of executing the optical modulation by combining a change in Faraday rotation angle by the modulation of the external magnetic field and the polarizer, it will be understood that the modulation amplitude of the optical modulator according to the invention is large because not only a degree of change in Faraday rotation angle is large but also a change in absorption is also used. In the embodiment, although the light has been input perpendicularly to the film surface, the invention can be also similarly applied to a waveguide type in which the light is input in parallel with the film surface.

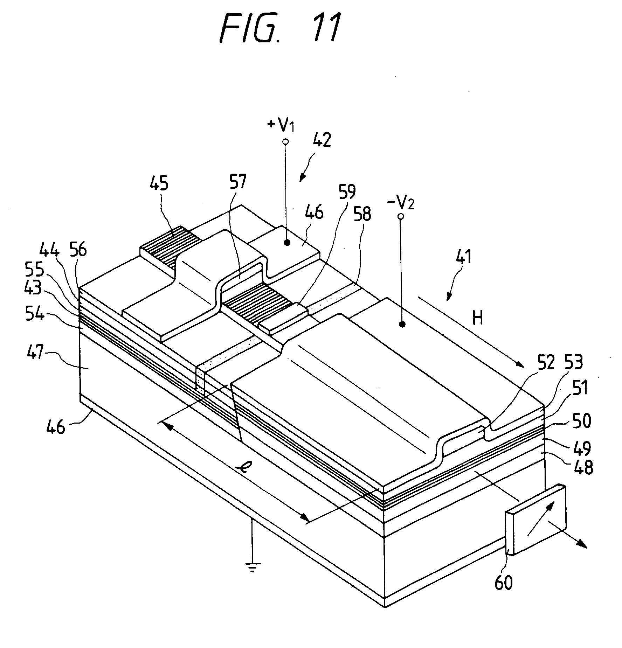

Fig. 11 is a schematic perspective view showing an embodiment in the case where the invention was applied to an optical isolator. The optical isolator intends to adjust the Faraday rotation angle by an electric field which is applied by using the foregoing principle. A device of the embodiment is constructed by monolithically forming an optical isolator and a semiconductor laser onto the same substrate.

In Fig. 11, an optical isolator section 41 and a distribution Bragg reflection (DBR) laser section 42 are integratedly formed on a substrate 47. The DBR laser section 42 is formed by laminating an active layer 43 and an optical waveguide layer 44. Gratings 45 constructing the DBR are formed on both sides of an electrode 46.

The optical isolator section 41 is formed on a portion which is obtained by cutting one side (right side in Fig. 11) of the laser section 42 by a taper etching process until the cut region reaches the substrate 47. The optical isolator section 41 is formed by sequentially laminating an n-C dTe buffer layer 48, an n-CdMnTe clad layer 49, an i-MQW layer 50, a p-CdMnTe clad layer 51, and a p+-CdTe contact layer 52 onto the substrate 47. Further, by eliminating parts of the clad layer 51 and the contact layer 52 by etching, a ridge is formed. The MQW layer 50 functions as a channel type optical waveguide by the ridge. Electrodes 53 to apply an electric field to the MQW layer are formed on the upper surfaces of the clad layer 51 and the contact layer 52. The electrode 46 which is common to the laser section 42 and the optical isolator section 41 is formed under the lower surface of the substrate 47.

In a manner similar to the case mentioned in the description of the principle mentioned above, the i-MQW layer 50 has a super lattice structure comprising a CdTe well layer and a CdMnTe barrier layer. The i-MQW layer 50 is optically coupled with the waveguide layer 44 of the DBR layer section 42.

In Fig. 11, reference numeral 54 denotes an n-A$\ell$GaAs layer; 55 a p-A$\ell$GaAs layer; 56 a p-A$\ell$GaAs layer; 57 a p+-GaAs contact layer; 58 an insulating section; 59 a metal loaded polarizer; and 60 a polarizer.

In the above construction, a laser beam which is oscillated by the active layer 43 of the DBR laser section 42 is converted into a TE mode wave by the metal loaded polarizer 59. The laser beam passes through the optical waveguide layer 44 and propagates in the MQW layer 50 of the optical isolator section 41. A magnetic field shown by an arrow H is applied from the outside to the MQW layer 50. Therefore, the polarizing direction of the propagation light is rotated by the magnetooptic effect for a period of time when the propagation light propagates in the MQW layer 50, that is, what is called a mode modulation is executed. The propagation light is emitted from an emission edge surface of the MQW layer 50 as a light whose polarizing direction is rotated by 45° and passes through the polarizer 60. The polarizer 60 is arranged so that a transmission axis (main axis) is set to the same direction as the polarizing direction of the emission light, that is, it is set so as to have an angle of 45° from the layer surface of the MQW layer.

On the other hand, the return light of the emission light passes through the polarizer 60 and reversely moves in the isolator section 41 and the polarizing direction is further rotated by 45°, so that the return light is converted into the TM mode wave. Therefore, the return light is absorbed by the metal loaded polarizer 59 and doesn't enter the DBR laser section 42.

At this time, the length $\ell$ of the optical isolator section 41 and the external magnetic field H are set so that the polarization plane of the laser beam is rotated by almost 45°. However, even if such a structure is merely used, there is a fear such that an error occurs in the Faraday rotation angle. To prevent such a problem, according to the invention, an inverse-bias voltage ($-V_2$) is applied to the pin structure of the optical isolator section 41. Due to this, the internal magnetic field is changed as described in the above principle and the Faraday rotation angle is finely adjusted. In this manner, the optical isolator can be finely adjusted so that the highest isolation ratio is derived.

As mentioned above, there is realized an optical isolator in which it is integrated together with the laser and a high isolation ratio can be obtained by finely adjusting the inverse-bias voltage even if the dimensional precision $\ell$ of the device and the set accuracy of the external magnetic field H are not so severe.

As described above, according to the invention, by using a method of modulating a degree of magnetooptic effect by applying an electric field, an optical modulator of a high speed and a large modulation amplitude, an optical isolator having a high isolation ratio, or the like can be realized.

Since those devices can be formed as films onto the semiconductor substrate such as a GaAs substrate by the MBE method or MO-CVD method, an optical integrated circuit in which the devices are integratedly formed together with the laser and photo sensitive element can be formed.

The invention is not limited to only the foregoing embodiments but many variations and modifications are possible. For instance, the invention is not limited to the optical modulator and the optical isolator but can be also applied to all of the devices which control the magnetooptic effect by applying an electric field.

**Claims**

1.  A magnetoopic device comprising:

    a substrate (31);
    a semiconductor layer having a quantum well structure (33, 50) formed on the substrate, in which the semiconductor layer is formed by alternately laminating a well layer (1) and a barrier layer (2) and at least the barrier layer (2) in said layers contains ions having a magnetic moment; means for applying a magnetic field to the semiconductor layer; and
    electrodes (35, 53) to apply an electric field to the semiconductor layer.

2.  A device according to claim 1, wherein the well layer and the barrier layer are made of either ones of: CdTe and CdMnTe; ZnSe and ZnMnSe; CdS and CdMnS; CdSe and CdMnSe; HgSe and HgMnSe; and HgTe and HgMnTe.

3.  A method of driving a magnetooptic device according to any of claims 1 and 2 comprising the steps of:

    inputting a light which is polarized in a predetermined direction into the semiconductor layer;
    applying a magnetic field to the semiconductor layer;
    applying an electric field to the semiconductor layer by the electrodes; and
    extracting the light transmitted by the semiconductor layer.

4.  A magnetooptic device according to any of claims 1 and 2, wherein

    said semiconductor layer transmits a light which entered from an outside; and
    the semiconductor layer is adapted such that when the electric field is applied thereto , the degree of leakage of a wave function of a charge carrier in the well layer (1) into the barrier layer (2) changes and an effective magnetic field acting on a charge carrier changes by an exchange interaction between the charge carrier spin and a magnetic moment associated with the ions having a magnetic moment, so that the degree of magnetooptic effect which is given to the transmissed light changes.

5.  A method of driving a magnetooptic device according to claim 3 wherein
    by applying the electric field to the semiconductor layer, the degree of leakage of a wave function of a charge carrier in the well layer (1) into the barrier layer (2) changes and an effective magnetic field acting on a charge carrier changes by an exchange interaction between the charge carrier spin and a magnetic moment associated with the ions having a magnetic moment, so that the degree of magnetooptic effect which is given to the transmissed light changes.

6.  A magnetooptic device comprising:

    a substrate (31);
    a first semiconductor layer (32) having a first doping polarity formed on the substrate;
    a multiple quantum well layer (33) formed on the first semiconductor layer, in which the multiple quantum well layer is formed by alternately laminating a well layer and a barrier layer and at least the barrier layer in said layers contains ions having a magnetic moment ;
    a second semiconductor layer (34) which is formed on the multiple quantum well layer and has a second doping polarity opposite to the first polarity;
    a first electrode (35) formed on the second semiconductor layer;
    a second electrode (35) formed under a lower surface of the substrate; and
    means for applying a magnetic field to the semiconductor layer.

7. A device according to claim 6, wherein the well layer and the barrier layer are made of either ones of: CdTe and CdMnTe; ZnSe and ZnMnSe; CdS and CdMnS; CdSe and CdMnSe; HgSe and HgMnSe; and HgTe and HgMnTe.

8. A method of driving a magnetooptic device according to any of claims 6 and 7 comprising the steps of:

> inputting a light which is polarizing in a predetermined direction into the multiple quantum well layer;
> applying a magnetic field to the multiple quantum well layer;
> applying a voltage of an inverse bias between the first and second electrodes; and
> extracting the light which is transmitted by the quantum well layer.

9. An optical modulator comprising:

> a substrate (31);
> a semiconductor layer which is formed on the substrate and has a quantum well structure (33) formed so as to transmit light which is polarized in a predetermined direction, in which the semiconductor layer is formed by alternately laminating a well layer and a barrier layer and at least the barrier layer in said layers contains ions having a magnetic moment;
> electrodes (35) to apply an electric field to the semiconductor layer; means for applying a magnetic field to the semiconductor layer; and
> a polarizer (36) for converting a rotation of a polarizing direction of the light which is transmitted by the semiconductor layer into an intensity modulation of the light.

10. An optical modulator according to claim 9, wherein holes for inputting the light into the semiconductor layer and extracting the light which is transmitted by the semiconductor layer are formed in the substrate and the electrodes.

11. An optical modulator according to claim 9, wherein a light absorption index of the semiconductor layer changes by a quantum confined Stark effect when the electric field is applied.

12. An optical modulator according to claim 9, wherein the well layer and the barrier layer are made of either ones of: CdTe and CdMnTe; ZnSe and ZnMnSe; CdS and CdMnS; CdSe and CdMnSe; HgSe and HgMnSe; and HgTe and HgMnTe.

13. A method of driving an optical modulator comprising a substrate (31); a semiconductor layer having a quantum well structure (33) formed on the substrate, said semiconductor layer being formed by alternately laminating a well layer and a barrier layer and at least the barrier layer in said layers containing ions having a magnetic moment; electrodes (35) to apply an electric field to the semiconductor layer; and a polarizer (36), said method comprising the steps of:

> inputting light ($I_1$) which is polarized in a predetermined direction into the semiconductor layer;
> applying a magnetic field ($B_0$) to the semiconductor layer;
> applying the electric field ($F$) to the semiconductor layer by the electrodes;
> extracting the light ($I_2$) whose polarizing direction is rotated and is transmitted by the semiconductor layer; and
> allowing the extracted light to pass through the polarizer and converting the rotation of the polarizing direction into an intensity modulation of the light ($I_3$).

14. An optical modulator according to any one of claims 9 to 12, wherein the semiconductor layer is adapted such that when the electric field is applied thereto, the degree of leakage of a wave function of a charge carrier in the well layer (1) into the barrier layer (2) changes and an effective magnetic field acting on a charge carrier changes by an exchange interaction between the charge carrier spin and a magnetic moment associated with the ions having a magnetic moment, so that the degree of magnetooptic effect which is given to the transmissed light changes.

15. A method of driving an optical modulator according to claim 13 wherein by applying the electric field to the semiconductor layer, the degree of leakage of a wave function of a charge carrier in the well layer (1) into the barrier layer (2) changes and an effective magnetic field acting on a charge carrier changes by an exchange interaction between the charge carrier spin and a magnetic moment associated with the ions having a magnetic moment, so that the degree of magnetooptic effect which is given to the transmissed light changes.

**16.** An optical isolator comprising:
a first polarizer to transmit light which is polarized in a predetermined direction;

a substrate (31) ;
a semiconductor layer having a quantum well structure (33) formed on the substrate such that the light which is transmitted through the first polarizer enters into the structure, wherein the semiconductor layer is formed by alternately laminating a well layer and a barrier layer and at least the barrier layer in said layers contains ions having a magnetic moment and the semiconductor layer is capable of rotating a polarizing direction of the incident light;
electrodes (35) to apply an electric field to the semiconductor layer; means for applying a magnetic field to the semiconductor layer; and
a second polarizer (36) to transmit the light which is transitted by the semiconductor layer.

**17.** An optical isolator according to claim 16, wherein an angle between transmission axes of said first and second polarizers is set to 45°.

**18.** An optical isolator according to claim 16, wherein the well layer and the barrier layer are made of either ones of: CdTe and CdMnTe; ZnSe and ZnMnSe; CdS and CdMnS; CdSe and CdMnSe; HgSe and HgMnSe; and HgTe and HgMnTe.

**19.** A method of adjusting an optical isolator according to any of claims 16 to 18 comprising the steps of:

inputting light which is transmitted by the first polarizer into the semiconductor layer;
applying a magnetic field to the semiconductor layer;
extracting the light whose polarizing direction is rotated by the semiconductor layer from the semiconductor layer;
inputting the extracted light into the second polarizer; and
applying the electric field from the electrodes to the semiconductor layer and adjusting the rotating angle of the polarizing direction of the light.

**20.** An optical isolator according to any of claims 16 to 18 wherein the semiconductor layer is adapted such that when the electric field is applied thereto, the degree of leakage of a wave function of a charge carrier in the well layer (1) into the barrier layer (2) changes and an effective magnetic field acting on a charge carrier changes by an exchange interaction between the charge carrier spin and a magnetic moment associated with the ions having a magnetic moment, so that the rotation angle of the polarizing direction of the transmitted light changes.

**21.** A method of adjusting an optical isolator according to claim 19, wherein
by applying the electric field to the semiconductor layer, the degree of leakage of a wave function of a charge carrier in the well layer (1) into the barrier layer (2) changes and an effective magnetic field acting on a charge carrier changes by an exchange interaction between the charge carrier spin and a magnetic moment associated with the ions having a magnetic moment and thereby adjusting the rotation angle of the polarizing direction of the transmitted light.

**22.** An optical isolator according to any one of claims 16 to 18 which further comprises

a first clad layer (49) having a first doping polarity formed on the substrate;
a second clad layer (51) having a doping polarity opposite to the first doping polarity;
wherein the semiconductor layer acts as a waveguide layer (50) and is formed between the first and second clad layers (49, 51); and
the waveguide layer propagates the incident light and rotates a polarizing direction of the incident light.

**23.** An optical isolator according to claim 22, wherein
the semiconductor layer is adapted such that when the electric field is applied to the waveguide layer (50), the degree of leakage of a wave function of a charge carrier in the well layer into the barrier layer changes and an effective magnetic field acting on a charge carrier changes by an exchange interaction between the charge carrier spin and a magnetic moment associated with the ions having a magnetic moment, so that the rotation angle of the polarizing direction of the transmitted light changes.

**24.** An optical isolator (41) which is integrated with a semiconductor laser (42), comprising:

a substrate (47);
a laser section (42) which is formed on the substrate and is constructed by a semiconductor active layer (43) to generate a laser beam when a current is supplied and a first electrode (46) to supply a current to the active layer; and
an isolator section (41) formed on the same substrate as that of the laser section, said isolator section comprising (1) a waveguide layer (50) formed by alternately laminating a well layer and a barrier layer, at least the barrier layer in said layers including ions having a magnetic moment, (2) a second electrode (53) to apply an electric field to the waveguide layer and (3) means for applying a magnetic field to the semiconductor layer.

**25.** An optical isolator according to claim 24, further comprising:

a first polarizer (59) provided between the laser section and the isolator section; and
a second polarizer (60) arranged in an optical path of light which is generated by the laser section and is propagated in the isolator section and is emitted.

**26.** An optical isolator according to claim 25, wherein an angle between transmission axes of the first and second polarizers is set to 45°.

**27.** An optical isolator according to claim 24, further comprising an insulating section provided between the laser section and the isolator section.

**28.** An optical isolator according to claim 24, wherein the well layer and the barrier layer are made of either ones of: CdTe and CdMnTe; ZnSe and ZnMnSe; CdS and CdMnS; CdSe and CdMnSe; HgSe and HgMnSe; and HgTe and HgMnTe.

**29.** An optical isolator according to claim 24, wherein the laser section further comprises a second waveguide layer for propagating the light emitted from the active layer and leading to the waveguide layer of the isolator section.

**30.** A method of driving a magnetooptic device according to claim 24 comprising the steps of:

generating a laser beam by supplying a current from the first electrode to the active layer;
applying a magnetic field to the waveguide layer;
propagating the laser beam generated in the active layer into the waveguide layer and rotating a polarizing direction of the laser beam; and
applying the electric field from the second electrode to the waveguide layer, thereby adjusting a rotation angle in the polarizing direction of the propagation light.

**Patentansprüche**

**1.** Magnetooptische Vorrichtung, umfassend:

ein Substrat (31);
eine Halbleiterschicht mit einer Quantentopfstruktur (33, 50), die auf dem Substrat gebildet ist, wobei die Halbleiterschicht durch abwechselndes Laminieren einer Topfschicht (1) und einer Barrierenschicht (2) gebildet ist und mindestens die Barrierenschicht (2) in den Schichten Ionen mit einem magnetischen Moment enthält;
Einrichtungen zum Anlegen eines Magnetfelds an die Halbleiterschicht; und
Elektroden (35, 53) zum Anlegen eines elektrischen Felds an die Halbleiterschicht.

**2.** Vorrichtung nach Anspruch 1, bei der die Topfschicht und die Barrierenschicht jeweils aus CdTe und CdMnTe; ZnSe und ZnMnSe; CdS und CdMnS; CdSe und CdMnSe; HgSe und HgMnSe; und HgTe und HgMnTe hergestellt sind.

**3.** Verfahren zum Betreiben einer magnetooptischen Vorrichtung nach einem der Ansprüche 1 und 2, umfassend die Schritte zum:

Eingeben von Licht, welches in einer vorbestimmten Richtung polarisiert ist, in die Halbleiterschicht;
Anlegen eines Magnetfelds an die Halbleiterschicht;
Anlegen eines elektrischen Felds an die Halbleiterschicht durch die Elektroden; und
Entziehen des durch die Halbleiterschicht durchgelassenen Lichts.

4. Magnetooptische Vorrichtung nach einem der Ansprüche 1 und 2, bei der

die Halbleiterschicht Licht durchläßt, welches von außen eingetreten ist; und
die Halbleiterschicht derart gestaltet ist, daß, wenn das elektrische Feld an sie angelegt wird, sich der Grad des Entweichens einer Wellenfunktion eines Ladungsträgers in der Topfschicht (1) in die Barrierenschicht (2) verändert, und ein effektives Magnetfeld, das auf einen Ladungsträger wirkt, sich durch eine Austauschwechselwirkung zwischen dem Spin des Ladungsträgers und einem mit den Ionen mit einem magnetischem Moment verknüpften magnetischen Moment verändert, so daß der Grad des magnetooptischen Effekts, der auf das durchgelassene Licht einwirkt, verändert wird.

5. Verfahren zum Betreiben einer magnetooptischen Vorrichtung nach Anspruch 3, wobei
durch Anlegen des elektrischen Felds an die Halbleiterschicht der Grad des Entweichens einer Wellenfunktion eines Ladungsträgers in der Topfschicht (1) in die Barrierenschicht (2) verändert wird und ein effektives Magnetfeld, das auf einen Ladungsträger wirkt, sich durch eine Austauschwechselwirkung zwischen dem Spin des Ladungsträgers und einem mit den Ionen mit einem magnetischem Moment verknüpften magnetischen Moment verändert, so daß der Grad des magnetooptischen Effekts, der auf das durchgelassene Licht einwirkt, verändert wird.

6. Magnetooptische Vorrichtung, umfassend:

ein Substrat (31);
eine erste Halbleiterschicht (32) mit einer ersten Polarität des Dotiermittels, die auf dem Substrat gebildet ist;
eine Mehrfach-Quantentopfschicht (33), die auf der ersten Halbleiterschicht gebildet ist, bei der die Mehrfach-Quantentopfschicht durch abwechselndes Laminieren einer Topfschicht und einer Barrierenschicht gebildet ist und mindestens die Barrierenschicht von diesen Schichten Ionen mit einem magnetischen Moment enthält;
eine zweite Halbleiterschicht (34), die auf der Mehrfach-Quantentopfschicht gebildet ist und eine zweite Polarität des Dotiermittels hat, die der ersten Polarität entgegengesetzt ist;
eine erste Elektrode (35), die auf der zweiten Halbleiterschicht gebildet ist;
eine zweite Elektrode (35), die unter einer unteren Oberfläche des Substrats gebildet ist; und
Einrichtungen zum Anlegen eines Magnetfelds an die Halbleiterschicht.

7. Vorrichtung nach Anspruch 6, bei der die Topfschicht und die Barrierenschicht jeweils aus CdTe und CdMnTe; ZnSe und ZnMnSe; CdS und CdMnS; CdSe und CdMnSe; HgSe und HgMnSe; und HgTe und HgMnTe hergestellt sind.

8. Verfahren zum Betreiben einer magnetooptischen Vorrichtung nach einem der Ansprüche 6 und 7, umfassend die Schritte zum:

Eingeben von Licht, welches in einer vorbestimmten Richtung polarisiert ist, in die Mehrfach-Quantentopfschicht;
Anlegen eines Magnetfelds an die Mehrfach-Quantentopfschicht;
Anlegen einer Rückwärtsspannung zwischen der ersten und der zweiten Elektrode; und
Entziehen des durch die Quantentopfschicht durchgelassenen Lichts.

9. Optischer Modulator, umfassend:

ein Substrat (31);
eine Halbleiterschicht, die auf dem Substrat gebildet ist und eine Quantentopfstruktur (33) hat, die so gebildet ist, daß Licht durchgelassen wird, das in einer vorbestimmten Richtung polarisiert ist, wobei die Halbleiterschicht durch abwechselndes Laminieren einer Topfschicht und einer Barrierenschicht gebildet ist und mindestens die Barrierenschicht in den Schichten Ionen mit einem magnetischen Moment enthält;
Elektroden (35), um ein elektrisches Feld an die Halbleiterschicht anzulegen;
Einrichtungen, um ein Magnetfeld an die Halbleiterschicht anzulegen;

einen Polarisator (36), um die Drehung einer Polarisationsrichtung des Lichts, das durch die Halbleiterschicht durchgelassen worden ist, in eine Intensitätsmodulation des Lichts zu verwandeln.

10. Optischer Modulator nach Anspruch 9, bei dem Löcher zum Eingeben von Licht in die Halbleiterschicht und zum Entziehen von Licht, das durch die Halbleiterschicht durchgelassen worden ist, in dem Substrat und den Elektroden gebildet sind.

11. Optischer Modulator nach Anspruch 9, bei dem sich ein Lichtabsorptionsindex der Halbleiterschicht durch den Stark-Effekt mit Einschluß durch Quanteneffekte ändert, wenn das elektrische Feld angelegt wird.

12. Optischer Modulator nach Anspruch 9, bei dem die Topfschicht und die Barrierenschicht jeweils aus CdTe und CdMnTe; ZnSe und ZnMnSe; CdS und CdMnS; CdSe und CdMnSe; HgSe und HgMnSe; und HgTe und HgMnTe hergestellt sind.

13. Verfahren zum Betreiben eines optischen Modulators, der ein Substrat (31); eine Halbleiterschicht mit einer Quantentopfstruktur (33), die auf dem Substrat gebildet ist, wobei die Halbleiterschicht durch abwechselndes Laminieren einer Topfschicht und einer Barrierenschicht gebildet ist und mindestens die Barrierenschicht in den Schichten Ionen mit einem magnetischen Moment enthält; Elektroden (35), um ein elektrisches Feld an die Halbleiterschicht anzulegen; und einen Polarisator (36) umfaßt, wobei das Verfahren die Schritte zum

Eingeben von Licht ($I_1$), welches in einer vorbestimmten Richtung polarisiert ist, in die Halbleiterschicht;
Anlegen eines Magnetfelds ($B_0$) an die Halbleiterschicht;
Anlegen des elektrischen Felds (F) an die Halbleiterschicht durch die Elektroden; und
Entziehen des Lichts ($I_2$), dessen Polarisationsrichtung gedreht worden ist und das durch die Halbleiterschicht durchgelassen worden ist; und
Zulassen, daß das entzogene Licht durch den Polarisator durchgeht, und Umwandeln der Drehung der Polarisationsrichtung in eine Intensitätsmodulation des Lichts ($I_3$),

umfaßt.

14. Optischer Modulator nach einem der Ansprüche 9 bis 12, bei dem die Halbleiterschicht so gestaltet ist, daß, wenn das elektrische Feld an sie angelegt wird, sich der Grad des Entweichens einer Wellenfunktion eines Ladungsträgers in der Topfschicht (1) in die Barrierenschicht (2) verändert, und ein effektives Magnetfeld, das auf einen Ladungsträger wirkt, sich durch eine Austauschwechselwirkung zwischen dem Spin des Ladungsträgers und einem mit den Ionen mit einem magnetischem Moment verknüpften magnetischen Moment verändert, so daß der Grad des magnetooptischen Effekts, der auf das durchgelassene Licht einwirkt, verändert wird.

15. Verfahren zum Betreiben eines optischen Modulators nach Anspruch 13, bei dem durch Anlegen des elektrischen Felds an die Halbleiterschicht der Grad des Entweichens einer Wellenfunktion eines Ladungsträgers in der Topfschicht (1) in die Barrierenschicht (2) verändert wird und ein effektives Magnetfeld, das auf einen Ladungsträger wirkt, sich durch eine Austauschwechselwirkung zwischen dem Spin des Ladungsträgers und einem mit den Ionen mit einem magnetischem Moment verknüpften magnetischen Moment verändert, so daß der Grad des magnetooptischen Effekts, der auf das durchgelassene Licht einwirkt, verändert wird.

16. Optischer Isolator, umfassend:

einen ersten Polarisator, um Licht durchzulassen, das in einer vorbestimmten Richtung polarisiert ist;
ein Substrat (31);
eine Halbleiterschicht mit einer Quantentopfstruktur (33), die auf dem Substrat gebildet ist, so daß Licht, das durch den ersten Polarisator durchgelassen worden ist, in die Struktur eintritt, wobei die Halbleiterschicht durch abwechselndes Laminieren einer Topfschicht und einer Barrierenschicht gebildet ist und mindestens die Barrierenschicht in den Schichten Ionen mit einem magnetischen Moment enthält und die Halbleiterschicht die Eigenschaft hat, die Polarisationsrichtung von dem einfallenden Licht zu drehen;
Elektroden (35), um ein elektrisches Feld an die Halbleiterschicht anzulegen;
Einrichtungen, um ein Magnetfeld an die Halbleiterschicht anzulegen;
einen zweiten Polarisator (36), um das Licht, das durch die Halbleiterschicht durchgelassen worden ist, durchzulassen.

**17.** Optischer Isolator nach Anspruch 16, bei dem ein Winkel zwischen den Durchlaßachsen des ersten und zweiten Polarisators auf 45° eingestellt ist.

**18.** Optischer Isolator nach Anspruch 16, bei dem die Topfschicht und die Barrierenschicht jeweils aus CdTe und CdMnTe; ZnSe und ZnMnSe; CdS und CdMnS; CdSe und CdMnSe; HgSe und HgMnSe; und HgTe und HgMnTe hergestellt sind.

**19.** Verfahren zum Einstellen eines optischen Isolators nach einem der Ansprüche 16 bis 18, umfassend die Schritte zum:

Eingeben von Licht, das durch den ersten Polarisator durchgelassen worden ist, in die Halbleiterschicht;
Anlegen eines Magnetfelds an die Halbleiterschicht;
Entziehen des Lichts, dessen Polarisationsrichtung durch die Halbleiterschicht gedreht worden ist, von der Halbleiterschicht;
Eingeben des entzogenen Lichts in den zweiten Polarisator;
Anlegen des elektrischen Felds von den Elektroden an die Halbleiterschicht und Einstellen des Drehwinkels des Polarisationsrichtung des Lichts.

**20.** Optischer Isolator nach einem der Ansprüche 16 bis 18, bei dem die Halbleiterschicht derart gestaltet ist, daß, wenn das elektrische Feld an sie angelegt wird, sich der Grad des Entweichens einer Wellenfunktion eines Ladungsträgers in der Topfschicht (1) in die Barrierenschicht (2) verändert, und ein effektives Magnetfeld, das auf einen Ladungsträger wirkt, sich durch eine Austauschwechselwirkung zwischen dem Spin des Ladungsträgers und einem mit den Ionen mit einem magnetischem Moment verknüpften magnetischen Moment verändert, so daß der Drehwinkel der Polarisationsrichtung des durchgelassenen Lichts verändert wird.

**21.** Verfahren zum Betreiben eines optischen Isolators nach Anspruch 19, bei dem durch Anlegen des elektrischen Felds an die Halbleiterschicht der Grad des Entweichens einer Wellenfunktion eines Ladungsträgers in der Topfschicht (1) in die Barrierenschicht (2) verändert wird und ein effektives Magnetfeld, das auf einen Ladungsträger wirkt, sich durch eine Austauschwechselwirkung zwischen dem Spin des Ladungsträgers und einem mit den Ionen mit einem magnetischem Moment verknüpften magnetischen Moment verändert, so daß der Drehwinkel der Polarisationsrichtung des durchgelassenen Lichts verändert wird.

**22.** Optischer Isolator nach einem der Ansprüche 16 bis 18, der ferner

eine erste Mantelschicht (49) mit einer ersten Polarität des Dotiermittels, die auf dem Substrat gebildet ist;
eine zweite Mantelschicht (51) mit einer zur ersten Polarität des Dotiermittels entgegengesetzten Polarität des Dotiermittels umfaßt;
wobei die Halbleiterschicht als ein Wellenleiter (50) wirkt und zwischen der ersten und der zweiten Mantelschicht (49, 51) gebildet ist; und
die Wellenleiterschicht das eintretende Licht sich fortbewegen läßt und eine Polarisationsrichtung des einfallenden Lichts dreht.

**23.** Optischer Isolator nach Anspruch 22, bei dem die Halbleiterschicht derart gestaltet ist, daß, wenn das elektrische Feld an die Wellenleiterschicht (50) angelegt wird, sich der Grad des Entweichens einer Wellenfunktion eines Ladungsträgers in der Topfschicht (1) in die Barrierenschicht (2) verändert, und ein effektives Magnetfeld, das auf einen Ladungsträger wirkt, sich durch eine Austauschwechselwirkung zwischen dem Spin des Ladungsträgers und einem mit den Ionen mit einem magnetischem Moment verknüpften magnetischen Moment verändert, so daß der Drehwinkel der Polarisationsrichtung des durchgelassenen Lichts verändert wird.

**24.** Optischer Isolator (41), der mit einem Halbleiterlaser (42) integriert ist, umfassend:

ein Substrat (47);
einen Laserabschnitt (42), der auf dem Substrat gebildet ist und durch eine aktive Halbleiterschicht (43) zum Erzeugen eines Laserstrahls, wenn ein Strom zugeführt wird, und durch eine erste Elektrode (46), um der aktiven Schicht einen Strom zuzuführen, aufgebaut ist; und
einen Isolatorabschnitt (41), der auf demselben Substrat wie der Laserabschnitt gebildet ist, wobei der Isolatorabschnitt

(1) eine Wellenleiterschicht (50), die durch abwechselndes Laminieren einer Topfschicht und einer Barrierenschicht gebildet ist, wobei mindestens die Barrierenschicht in den Schichten Ionen mit einem magnetischen Moment enthält,

(2) eine zweite Elektrode (53), um ein elektrisches Feld an die Wellenleiterschicht anzulegen und

(3) Einrichtungen, um ein Magnetfeld an die Halbleiterschicht anzulegen, umfaßt.

**25.** Optischer Isolator nach Anspruch 24, ferner umfassend:

einen ersten Polarisator (59), der zwischen dem Laserabschnitt und dem Isolatorabschnitt bereitgestellt ist; und

einen zweiten Polarisator (60), der in einem optischen Weg von Licht angeordnet ist, das von dem Laserabschnitt erzeugt wird und sich in dem Isolatorabschnitt fortbewegt und emittiert wird.

**26.** Optischer Isolator nach Anspruch 25, bei dem ein Winkel zwischen den Durchlaßachsen des ersten und zweiten Polarisators auf 45° eingestellt ist.

**27.** Optischer Isolator nach Anspruch 24, ferner umfassend einen Isolierabschnitt, der zwischen dem Laserabschnitt und dem Isolatorabschnitt bereitgestellt ist.

**28.** Optischer Isolator nach Anspruch 24, bei dem die Topfschicht und die Barrierenschicht jeweils aus CdTe und CdMnTe; ZnSe und ZnMnSe; CdS und CdMnS; CdSe und CdMnSe; HgSe und HgMnSe; und HgTe und HgMnTe hergestellt sind.

**29.** Optischer Isolator nach Anspruch 24, bei dem der Laserabschnitt ferner eine zweite Wellenleiterschicht zur Fortbewegung des von der aktiven Schicht emittierten Lichts umfaßt, die zu der Wellenleiterschicht des Isolatorabschnitts führt.

**30.** Verfahren zum Betreiben einer magnetooptischen Vorrichtung nach Anspruch 24, umfassend die Schritte zum:

Erzeugen eines Laserstrahls durch Zuführen eines Stroms von der ersten Elektrode zu der aktiven Schicht;

Anlegen eines Magnetfelds an die Wellenleiterschicht;

Fortbewegenlassen des in der aktiven Schicht erzeugten Laserstrahls in die Wellenleiterschicht und Drehen einer Polarisationsrichtung des Laserstrahls; und

Anlegen des elektrischen Felds von der zweiten Elektrode an die Wellenleiterschicht, wodurch ein Drehwinkel in der Polarisationsrichtung des Fortbewegungslichts eingestellt wird.

## Revendications

**1.** Dispositif magnéto-optique comprenant :

un substrat (31) ;

une couche semiconductrice ayant une structure (33, 50) de puits quantique formée sur le substrat, dans lequel la couche semiconductrice est formée en stratifiant de façon alternée une couche (1) de puits et une couche (2) d'arrêt et dans laquelle la couche (2) d'arrêt appartenant auxdites couches contient des ions ayant un moment magnétique ;

des moyens pour appliquer un champ magnétique à la couche semiconductrice ; et

des électrodes (35, 53) pour appliquer un champ électrique à la couche semiconductrice.

**2.** Dispositif selon la revendication 1, dans lequel la couche de puits et la couche d'arrêt sont faites de l'un quelconque de : CdTe et CdMnTe ; ZnSe et ZnMnSe ; CdS et CdMnS ; CdSe et CdMnSe ; HgSe et HgMnSe ; et HgTe et HgMnTe.

**3.** Procédé d'attaque d'un dispositif magnéto-optique selon l'une quelconque des revendications 1 et 2, comprenant les étapes qui consistent :

à introduire une lumière qui est polarisée dans une direction prédéterminée dans la couche semiconductrice ;

à appliquer un champ magnétique à la couche semiconductrice ;

à appliquer un champ électrique à la couche semiconductrice au moyen des électrodes ; et

à extraire la lumière transmise par la couche semiconductrice.

4. Dispositif magnéto-optique selon l'une quelconque des revendications 1 et 2, dans lequel

ladite couche semiconductrice transmet une lumière qui est introduite de l'extérieur ; et

la couche semiconductrice est adaptée de telle façon que lorsque le champ électrique lui est appliqué, le degré de fuite d'une fonction d'onde d'un porteur de charge se trouvant dans la couche (1) de puits vers l'intérieur de la couche (2) d'arrêt varie, et un champ magnétique efficace agissant sur le porteur de charge varie sous l'effet d'une interaction d'échange entre le spin du porteur de charge et le moment magnétique associé aux ions ayant un moment magnétique, de sorte que le degré d'effet magnéto-optique qui est conféré à la lumière transmise varie.

5. Procédé d'attaque d'un dispositif magnéto-optique selon la revendication 3, dans lequel

en appliquant le champ électrique à la couche semiconductrice, le degré de fuite d'une fonction d'onde d'un porteur de charge se trouvant dans la couche (1) de puits vers l'intérieur de la couche (2) d'arrêt varie, et un champ magnétique effectif agissant sur le porteur de charge varie sous l'effet d'une interaction d'échange entre le spin du porteur de charge et un moment magnétique associé aux ions ayant un moment magnétique, de sorte que le degré d'effet magnéto-optique qui est conféré à la lumière transmise varie.

6. Dispositif magnéto-optique comprenant :

un substrat (31) ;

une première couche (32) semiconductrice ayant une première polarité de dopage formée sur le substrat ;

une couche (33) à puits quantiques multiples formée sur la première couche semiconductrice, la couche à puits quantiques multiples étant formée par stratification alternée d'une couche de puits et d'une couche d'arrêt et au moins la couche d'arrêt appartenant auxdites couches contenant des ions ayant un moment magnétique ;

une seconde couche (34) semiconductrice qui est formée sur la couche à puits quantiques multiples et qui a une seconde polarité de dopage opposée à la première polarité ;

une première électrode (35) formée sur la seconde couche semiconductrice ;

une seconde électrode (35) formée sous une surface inférieure du substrat ; et

des moyens pour appliquer un champ magnétique à la couche semiconductrice.

7. Dispositif selon la revendication 6, dans lequel la couche de puits et la couche d'arrêt sont faites de l'un ou l'autre de : CdTe et CdMnTe ; ZnSe et ZnMnse ; CdS et CdMnS ; CdSe et CdMnSe ; HgSe et HgMnSe ; et HgTe et HgMnTe.

8. Procédé d'attaque d'un dispositif magnéto-optique selon l'une quelconque des revendications 6 et 7, comprenant les étapes qui consistent :

à introduire une lumière qui est polarisée dans une direction prédéterminée dans la couche à puits quantiques multiples ;

à appliquer un champ magnétique à la couche à puits quantiques multiples ;

à appliquer une tension de polarisation inverse entre les première et seconde électrodes ; et

à extraire la lumière qui est transmise par la couche à puits quantiques multiples.

9. Modulateur optique comprenant :

un substrat (31) ;

une couche semiconductrice qui est formée sur le substrat et a une structure (33) de puits quantique formée de façon à transmettre de la lumière qui est polarisée dans une direction prédéterminée, la couche semiconductrice étant formée par stratification alternée d'une couche de puits et d'une couche d'arrêt et au moins la couche d'arrêt appartenant auxdites couches contenant des ions ayant un moment magnétique ;

des électrodes (35) pour appliquer un champ électrique à la couche semiconductrice ;

des moyens pour appliquer un champ magnétique à la couche semiconductrice ; et

un polariseur (36) pour convertir une rotation de la direction de polarisation de la lumière qui est transmise par la couche semiconductrice en une modulation d'intensité de la lumière.

**10.** Modulateur optique selon la revendication 9, dans lequel les trous destinés à l'introduction de la lumière dans la couche semiconductrice et à extraire la lumière qui est transmise par la couche semiconductrice, sont formés dans le substrat et les électrodes.

**11.** Modulateur optique selon la revendication 9, dans lequel l'indice d'absorption de la lumière de la couche semiconductrice varie en raison d'un effet Stark de confinement quantique lorsque le champ électrique est appliqué.

**12.** Modulateur optique selon la revendication 9, dans lequel la couche de puits et la couche d'arrêt sont faites de l'un ou l'autre de : CdTe et CdMnTe ; ZnSe et ZnMnSe ; CdS et CdMnS ; CdSe et CdMnSe ; HgSe et HgMnSe; et HgTe et HgMnTe.

**13.** Procédé d'attaque d'un modulateur optique comprenant un substrat (31) ; une couche semiconductrice ayant une structure (33) de puits quantique formée sur le substrat, ladite couche semiconductrice étant formée par stratification alternée d'une couche de puits et d'une couche d'arrêt, et au moins la couche d'arrêt appartenant auxdites couches contenant des ions ayant un moment magnétique ; des électrodes (35) destinées à appliquer un champ électrique à la couche semiconductrice ; et un polariseur (36), ledit procédé comprenant les étapes qui consistent :

à introduire une lumière ($I_1$) qui est polarisée dans une direction prédéterminée dans la couche semiconductrice ;
à appliquer un champ ($B_0$) magnétique à la couche semiconductrice ;
à appliquer le champ (F) électrique à la couche semiconductrice au moyen des électrodes ;
à extraire la lumière ($I_2$) dont la direction de polarisation a subi une rotation et qui est transmise par la couche semiconductrice ; et
à laisser passer la lumière extraite à travers le polariseur et à convertir la rotation de la direction de polarisation en une modulation d'intensité de la lumière ($I_3$).

**14.** Modulateur optique selon l'une quelconque des revendications 9 à 12, dans lequel
la couche semiconductrice est adaptée de telle façon que lorsque le champ électrique lui est appliqué, le degré de fuite d'une fonction d'onde d'un porteur de charge se trouvant dans la couche (1) de puits vers l'intérieur de la couche (2) d'arrêt varie, et le champ magnétique efficace agissant sur le porteur de charge varie sous l'effet d'une interaction d'échange entre le spin du porteur de charge et le moment magnétique associé aux ions ayant un moment magnétique, de sorte que le degré d'effet magnéto-optique qui est conféré à la lumière transmise varie.

**15.** Procédé d'attaque d'un modulateur optique selon la revendication 13, dans lequel,
en appliquant le champ électrique à la couche semiconductrice, le degré de fuite d'une fonction d'onde d'un porteur de charge se trouvant dans la couche (1) de puits vers l'intérieur de la couche (2) d'arrêt varie, et un champ magnétique efficace agissant sur le porteur de charge varie sous l'effet d'une interaction d'échange entre le spin du porteur de charge et le moment magnétique associé aux ions ayant un moment magnétique, de sorte que le degré d'effet magnéto-optique qui est conféré à la lumière transmise varie.

**16.** Isolateur optique comprenant :

un premier polariseur destiné à transmettre de la lumière qui est polarisée dans une direction prédéterminée ;
un substrat (31) ;
une couche semiconductrice ayant une structure (33) de puits quantique formée sur le substrat de telle façon que la lumière qui est transmise à travers le premier polariseur atteigne la structure, la couche semiconductrice étant formée par stratification alternée d'une couche de puits et d'une couche d'arrêt et au moins la couche d'arrêt appartenant auxdites couches contenant des ions ayant un moment magnétique et la couche semiconductrice étant capable de faire tourner une direction de polarisation de la lumière incidente ;
des électrodes (35) destinées à appliquer un champ électrique à la couche semiconductrice ;
des moyens destinés à appliquer un champ magnétique à la couche semiconductrice ; et
un second polariseur (36) pour transmettre la lumière qui est transmise par la couche semiconductrice.

**17.** Isolateur optique selon la revendication 16, dans lequel l'angle entre les axes de transmission desdits premier et second polariseurs est fixé à 45°.

**18.** Isolateur optique selon la revendication 16, dans lequel la couche de puits et la couche d'arrêt sont faites de l'un ou l'autre de : CdTe et CdMnTe ; ZnSe et ZnMnSe ; CdS et CdMnS ; CdSe et CdMnSe ; HgSe et HgMnSe ; et HgTe et HgMnTe.

**19.** Procédé d'ajustement d'un isolateur optique selon l'une quelconque des revendications 16 à 18, comprenant les étapes qui consistent :

à introduire de la lumière qui est transmise par le premier polariseur dans la couche semiconductrice ;
à appliquer un champ magnétique à la couche semiconductrice ;
à extraire de la couche semiconductrice la lumière dont la direction de polarisation est soumise à une rotation par la couche semiconductrice ;
à introduire la lumière extraite dans le second polariseur ; et
à appliquer le champ électrique au moyen des électrodes à la couche semiconductrice et à ajuster l'angle de rotation de la direction de polarisation de la lumière.

**20.** Isolateur optique selon l'une quelconque des revendications 16 à 18, dans lequel la couche semiconductrice est adaptée de telle façon que lorsque le champ électrique lui est appliqué, le degré de fuite d'une fonction d'onde d'un porteur de charge se trouvant dans la couche (1) de puits vers l'intérieur de la couche (2) d'arrêt varie, et un champ magnétique efficace agissant sur un porteur de charge varie sous l'effet d'une interaction d'échange entre le spin du porteur de charge et le moment magnétique associé aux ions ayant un moment magnétique, de sorte que l'angle de rotation de la direction de polarisation de la lumière transmise varie.

**21.** Procédé d'ajustement d'un isolateur optique selon la revendication 19, dans lequel en appliquant le champ électrique à la couche semiconductrice, le degré de fuite d'une fonction d'onde d'un porteur de charge se trouvant dans la couche (1) de puits vers l'intérieur de la couche (2) d'arrêt varie, et un champ magnétique efficace agissant sur le porteur de charge varie sous l'effet d'une interaction d'échange entre le spin du porteur de charge et le moment magnétique associé aux ions ayant un moment magnétique, de façon à ajuster ainsi l'angle de rotation de la direction de polarisation de la lumière transmise.

**22.** Isolateur optique selon l'une quelconque des revendications 16 à 18, comprenant en outre :

une première couche (49) de placage ayant une première polarité de dopage formée sur le substrat ;
une seconde couche (51) de placage ayant une polarité de dopage opposée à la première polarité de dopage ;
la couche semiconductrice jouant le rôle de couche (50) de guide d'ondes et étant formée entre les première et seconde couches (49, 51) de placage ; et
la couche de guide d'ondes assurant la propagation de la lumière incidente et faisant tourner la direction de polarisation de la lumière incidente.

**23.** Isolateur optique selon la revendication 22, dans lequel la couche semiconductrice est adaptée de telle façon que lorsqu'un champ électrique est appliqué à la couche (50) de guide d'ondes, le degré de fuite d'une fonction d'onde d'un porteur de charge se trouvant dans la couche de puits vers l'intérieur de la couche d'arrêt varie, et un champ magnétique efficace agissant sur le porteur de charge varie sous l'effet d'une interaction d'échange entre le spin du porteur de charge et un moment magnétique associé aux ions ayant un moment magnétique, de sorte que l'angle de rotation de la direction de polarisation de la lumière transmise varie.

**24.** Isolateur (41) optique intégré à un laser (42) à semiconducteur, comprenant :

un substrat (47) ;
une section (42) à laser qui est formée sur le substrat et est constituée par une couche (43) active semiconductrice afin de produire un faisceau laser lorsqu'un courant est fourni et une première électrode (46) pour fournir un courant à la couche active ; et
une section (41) isolatrice formée sur le même substrat que celui de la section à laser, ladite section isolatrice comprenant (1) une couche (50) de guide d'ondes formée par stratification alternée d'une couche de puits et d'une couche d'arrêt, au moins une couche d'arrêt appartenant auxdites couches contenant des ions ayant un moment magnétique, (2) une seconde électrode (53) destinée à appliquer un champ électrique à la couche de guide d'ondes et (3) des moyens destinés à appliquer un champ magnétique à la couche semiconductrice.

**25.** Isolateur optique selon la revendication 24, comprenant en outre :

un premier polariseur (59) disposé entre la section à laser et la section isolatrice ; et
un second polariseur (60) disposé sur un chemin optique de la lumière qui est produite par la section à laser et qui se propage dans la section isolatrice et est émise.

26. Isolateur optique selon la revendication 25, dans lequel l'angle entre les axes de transmission des premier et second polariseurs est fixé à 45°.

27. Isolateur optique selon la revendication 24, comprenant en outre une section d'isolation disposée entre la section à laser et la section isolatrice.

28. Isolateur optique selon la revendication 24, dans lequel la couche de puits et la couche d'arrêt sont faites de l'un ou l'autre de : CdTe et CdMnTe ; ZnSe et ZnMnSe ; CdS et CdMnS ; CdSe et CdMnSe ; HgSe et HgMnSe ; et HgTe et HgMnTe.

29. Isolateur optique selon la revendication 24, dans lequel la section à laser comprend en outre une seconde couche de guide d'ondes pour la propagation de la lumière émise par la couche active et conduisant à la couche de guide d'ondes de la section isolatrice.

30. Procédé d'attaque d'un dispositif magnéto-optique selon la revendication 24, comprenant les étapes qui consistent :

à produire un faisceau laser en fournissant un courant à la couche active au moyen de la première électrode ;
à appliquer un champ magnétique à la couche de guide d'ondes ;
à faire se propager le faisceau laser produit dans la couche active dans la couche de guide d'ondes et à faire tourner la direction de polarisation du faisceau laser ; et
à appliquer le champ électrique à la couche de guide d'ondes au moyen de la seconde électrode, afin d'ajuster ainsi l'angle de rotation de la direction de polarisation de la lumière de propagation.

## FIG. 1 PRIOR ART

## FIG. 2 PRIOR ART

## FIG. 3A
## PRIOR ART

OPTICAL TRANSMISSION

$\lambda = 8608\mathring{A}$

80%

60%

40%

0  4  8  12

APPLIED VOLTAGE (V)

## FIG. 3B
## PRIOR ART

OPTICAL TRANSMISSION

$\lambda = 8594\mathring{A}$

80%

60%

40%

0  4  8  12

APPLIED  VOLTAGE (V)

## FIG. 3C
## PRIOR ART

OPTICAL TRANSMISSION

$\lambda = 8580\mathring{A}$

80%

60%

40%

0  4  8  12

APPLIED VOLTAGE (V)

## FIG. 3D
## PRIOR ART

OPTICAL TRANSMISSION

$\lambda = 8562\mathring{A}$

80%

60%

40%

0  4  8  12

APPLIED  VOLTAGE (V)

# FIG. 4 PRIOR ART

# FIG. 5 PRIOR ART

FIG. 6A

FIG. 6B

# FIG. 7A

# FIG. 7B

## FIG. 8

## FIG. 9

## FIG. 10

# FIG. 11